# EUROPEAN PATENT APPLICATION

(11) **EP 4 730 647 A1**
(43) Date of publication of application: **22.04.2026**
(21) Application number: 24275110.5
(22) Date of filing: 15.10.2024
(51) Int. Cl.: H03C 3/22, H03H 17/08, H03D 3/02, H03D 3/08

(54) **RECEIVER AND PHASE MODULATOR BEING PART OF THE RECEIVER AND CORRESPONDING METHOD**

(71) Applicant: BAE SYSTEMS plc, London SW1Y 5AD (GB)
(72) Inventor: The designation of the inventor has not yet been filed
(74) Representative: BAE SYSTEMS plc Group IP Department

(57) **Abstract**

An apparatus is described comprising a plurality of phase modulator pairs arranged in series, each phase modulator pair comprising a first phase modulator and a second phase modulator. The modulators of the first pair of the plurality receive a modulation signal and a carrier signal. Each modulator pair includes a phase shift circuit for phase shifting the carrier signal based on the modulation signal. The modulators of the last pair of the plurality provide outputs of carrier signals modulated based on the modulation signal.

## Description

### FIELD

The present invention relates to receiver circuitry and to phase modulator circuitry that may be used as part of the receiver circuitry, and to methods of using such circuitry. In particular the phase modulator circuitry may be used to condition advantageously an input signal prior to analogue to digital conversion.

### BACKGROUND

Radio receiver circuits are prone to noise and other forms of interference, such as in a congested signal environment or in the presence of a jamming signal. The circuitry and methods described herein have been developed in this context.

### SUMMARY

According to a first aspect of the present invention, there is provided an apparatus comprising a plurality of phase modulator pairs arranged in series, each phase modulator pair comprising a first phase modulator and a second phase modulator, each having a first input, a second input and an output, wherein: the first input of the first phase modulator of the first phase modulator pair of the plurality is coupled to a carrier signal input of the apparatus and the first input of the first phase modulators of the other phase modulator pairs are coupled to the output of the preceding first phase modulator of the plurality; the first input of the second phase modulator of the first phase modulator pair of the plurality is coupled to the carrier signal input of the apparatus and the first input of the second phase modulators of the other phase modulator pairs are coupled to the output of the preceding second phase modulator of the plurality; the second input of each first and second phase modulator is coupled to a modulation signal input of the apparatus; the outputs of the first and second phase modulators of the last phase modulator pair of the plurality are coupled to first and second outputs of the apparatus respectively (such that, in use, the first and second outputs provide first and second phase modulated carrier signals respectively, wherein the first and second phase modulated carrier signals are modulated based on a modulation signal (e.g. a from a radio signal) presented at the modulation signal input); each first phase modulator of the plurality further comprises a phase shift circuit for phase shifting a signal at the respective first input based on a signal at the respective second input, wherein the phase shift is dependent on the capacitance of variable capacitance diodes of the respective first phase modulator, said capacitance being dependent on the signal received at the second input, wherein the first phase modulator has a positive phase-voltage slope; and each second phase modulator of the plurality further comprises a phase shift circuit for phase shifting a signal at the respective first input based on a signal at the respective second input, wherein the phase shift is dependent on the capacitance of variable capacitance diodes of the respective second phase modulator, said capacitance being dependent on the signal received at the second input, wherein the second phase modulator has a negative phase-voltage slope.

In some example embodiments, the first phase modulator and the second phase modulator of each phase modulator pair produce the same nominal magnitude of phase signal change for the same signal on the third input, but with different sign. The magnitude may, for example, be the same to within manufacturing tolerances.

Each phase modulator pair of the plurality may be the same (or, for example, the same to within manufacturing tolerances).

The apparatus may further comprise a transmission line connecting the second input of each phase modulator of the plurality to the second input of each neighbouring phase modulator of the plurality. Alternatively, the apparatus may further comprise a pair of transmission lines, a first transmission line of the pair connecting together the second inputs of some (e.g. odd numbered) phase modulators of the plurality and a second transmission line of the pair connecting together the second inputs of other (e.g. even numbered) phase modulators of the plurality. The transmission line(s) may be formed from a combination of series inductive elements and shunt capacitive elements which include the input capacitance of the second inputs of each phase modulator pair. The transmission line(s) may be terminated by a terminating resistance matched to the characteristic impedance of the respective transmission line.

In some example embodiments, each phase shift circuit of each first and second modulator comprises a four port quadrature hybrid coupler. Each four port quadrature hybrid coupled may have a variable capacitance shunt load connected to two of its ports, with the other ports used for input and phase-shifted outputs. The hybrid couplers may be arranged such that there is a strong coupling between the input and output ports at an operational frequency range.

The apparatus may further comprise: one or more first delay circuits coupling at least some (e.g. all) of the outputs of the first phase modulators and the first inputs of the next first phase modulator of the plurality; and one or more second delay circuits coupling at least some (e.g. all) of the outputs of the second phase modulators and the first inputs of the next second phase modulator of the plurality. Each delay circuit may be provided by a serpentine connector track with a characteristic impedance matched to that of modulated signal path. Alternative delay circuits could be provided, such as a delay circuit constructed from lumped components. The first and second delay circuits may be provided such that overall delays experienced by modulated carrier signals passing through the first and second phase modulators approximately match overall delays experienced a modulation signal received at the modulation signal input.

The apparatus may further comprise: one or more first amplifiers coupling at least some of the outputs of the first phase modulators and the first inputs of the next first phase modulator of the plurality; and one or more second amplifiers coupling at least some of the outputs of the second phase modulators and the first inputs of the next second phase modulator of the plurality.

The said variable capacitance diodes of each first phase modulator may have an opposite polarity to corresponding variable capacitance diodes of each second phase modulator.

The apparatus may further comprise a control input for each variable capacitance diode to control reverse biasing of said variable capacitance diodes.

The apparatus may further comprise a carrier signal generation module for generating a carrier signal coupled to the carrier signal input of the apparatus.

The apparatus may further comprise an antenna for receiving radio signals for coupling to the modulation signal input of the apparatus.

Some example embodiments further comprise first and second analogue-to-digital converters for generating first and second digital phase signals based on the first and second outputs of the apparatus respectively. A differential digital phase demodulator may be provided for generating a digital output based on the first and second digital phase signals.

According to a second aspect of the present invention, there is provided a method comprising: coupling a first input of a first phase modulator of a first phase modulator pair of a plurality of phase modulator pairs to a carrier signal input, wherein first inputs of first phase modulators of other phase modulator pairs of the plurality are coupled to an output of the preceding first phase modulator of the plurality; coupling a first input of a second phase modulator of the first phase modulator pair of the plurality to the carrier signal input, wherein first inputs of second phase modulators of the other phase modulator pairs are coupled to an output of the preceding second phase modulator of the plurality; coupling a second input of each first and second phase modulator to a modulation signal input; coupling outputs of the first and second phase modulators of the last phase modulator pair of the plurality to first and second outputs; phase shifting a signal at the respective first input of each first phase modulator of the plurality based on a signal at the respective second input, wherein the phase shift is dependent on the capacitance of variable capacitance diodes of the respective first phase modulator, said capacitance being dependent on the signal received at the second input, wherein the first phase modulator has a positive phase-voltage slope; and phase shifting a signal at the respective first input of each second phase modulator of the plurality based on a signal at the respective second input, wherein the phase shift is dependent on the capacitance of variable capacitance diodes of the respective second phase modulator, said capacitance being dependent on the signal received at the second input, wherein the second phase modulator has a negative phase-voltage slope.

In some example embodiments, the first phase modulator and the second phase modulator of each phase modulator pair produce the same nominal magnitude of phase signal change for the same signal on the third input, but with different sign. The magnitude may, for example, be the same to within manufacturing tolerances.

Some example embodiments further comprise connecting the second input of each phase modulator of the plurality to the second input of each neighbouring phase modulator of the plurality using a transmission line or a pair of transmission lines. The transmission line(s) may be formed from a combination of series inductive elements and shunt capacitive elements which include the input capacitance of the second inputs of each phase modulator pair. The transmission line(s) may be terminated by a terminating resistance matched to the characteristic impedance of the respective transmission line.

Some example embodiments further comprise introducing delays to modulated carrier signals passing through the first and second phase modulators. The said delays may approximately match overall delays experienced by a radio signal received at the modulation signal input.

Some example embodiments further comprise amplifying outputs of at least some of the outputs of the first phase modulators and at least some of the outputs of the second phase modulators.

Some example embodiments further comprise generating first and second digital phase signals based on the first and second outputs. Some example embodiments further comprise generating a digital output based on the first and second digital phase signals.

According to a third aspect of the present invention, there is provided a computer-readable medium (such as a non-transitory computer-readable medium) comprising program instructions stored thereon for performing (at least) any method as described herein (including the methods of the second aspect described above).

According to a fourth aspect of the present invention, there is provided an apparatus comprising: at least one processor; and at least one memory storing instructions that, when executed by the at least one processor, causes the apparatus to perform (at least) any method as described herein (including the methods of the second aspect described above).

### BRIEF DESCRIPTION OF THE FIGURES

Embodiments of the invention will now be described by way of example only with reference to the figures, in which:
Figure 1 shows a receiver circuit;
Figure 2 is a flow chart showing an example operation of the circuit of Figure 1;
Figure 3 is a block diagram of a receiver circuit in accordance with an example embodiment;
Figure 4 is a flow chart showing an example operation of the circuit of Figure 3;
Figure 5 is a flow chart showing functionality of an example demodulator in accordance with an example embodiment;
Figure 6 is a block diagram of a digital demodulator circuit in accordance with an example embodiment;
Figure 7 is a block diagram of a phase modulator circuit;
Figure 8 is a block diagram showing a pair of phase modulator circuits in accordance with an example embodiment;
Figures 9 to 14 are block diagrams of phase modulator circuits in accordance with example embodiments;
Figure 15 is a block diagram of a receiver circuit in accordance with an example embodiment; and
Figure 16 shows a system that can be used in implementations of example embodiments.

### DETAILED DESCRIPTION

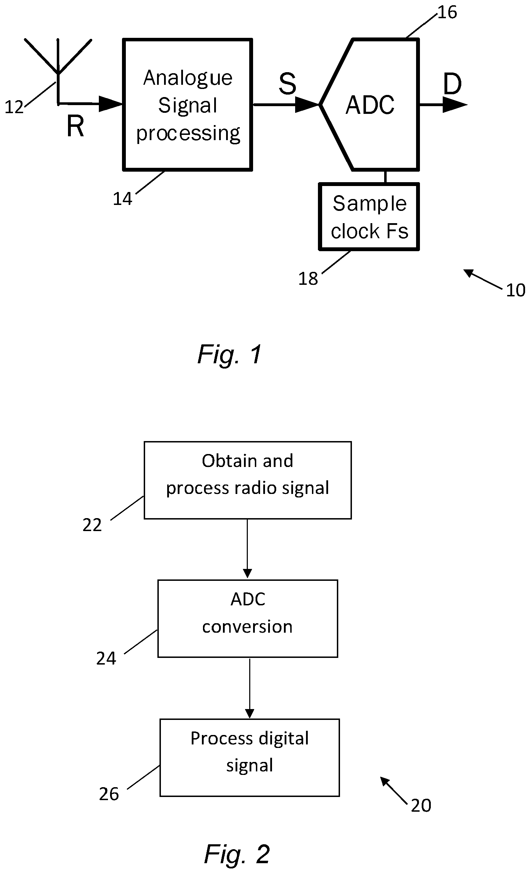

Figure 1 shows a receiver circuit, indicated generally by the reference numeral 10. The system 10 comprises an antenna 12, an analogue signal processing (ASP) circuit 14 and an analogue-to-digital converter (ADC) 16. The ADC 16 receives a clock signal (Fₛ) from a clock circuit 18.
Figure 2 is a flow chart, indicated generally by the reference numeral 20, showing an example operation of the circuit 10.

The algorithm 20 starts at step 22, where radio signals R received by the antenna 12 are subject to analogue signal processing by the signal processor 14 to form an analogue signal S. The signal processor 14 may include any, none or multiples of: a pre-selection filter, an attenuator (which may be variable), a low noise amplifier, a mixer stage fed by a local oscillator, an intermediate frequency filter, etc. The signal processor 14 may seek to select the part of the radio spectrum of interest and to reject (or at least suppress) unwanted signals on the basis of frequency.

At step 24, the signal S is sampled using the ADC 16 to provide a digital signal D. The ADC sample rate Fₛ should be sufficient to at least capture the bandwidth of interest.

At step 26, the digital signal D may be subject to further digital signal processing, for example to extract a payload (e.g. some additional information content, such as demodulation of AM, FM, DAB etc.).

The sensitivity of the receiver circuit 10 (i.e. the minimum detectable signal) is determined, at least in part, by the noise performance of the ADC 16. The effect of ADC noise can be mitigated by ensuring that the signal processor 14 has power gain and low self-noise. As the power gain of the signal processor 14 is increased, the sensitivity of the receiver 10 tends to improve until it is no longer limited by ADC noise.

The maximum input signal at the ADC 16 before saturation is a factor relevant to the maximum input signal within the bandwidth selected by the signal processor 14. The maximum input signal R within the selected bandwidth decreases in proportion to increases in the signal processor gain.

Thus, ADC performance for a given gain setting of the signal processor 14 is a factor in both the minimum detectable signal and the maximum input signal before saturation. Defences against jamming and strong signal interference include: filtering by frequency using the analogue signal processor 14 and reduction of the signal processor gain. The first constrains the operating frequency range of the receiver, whilst the second degrades the sensitivity.

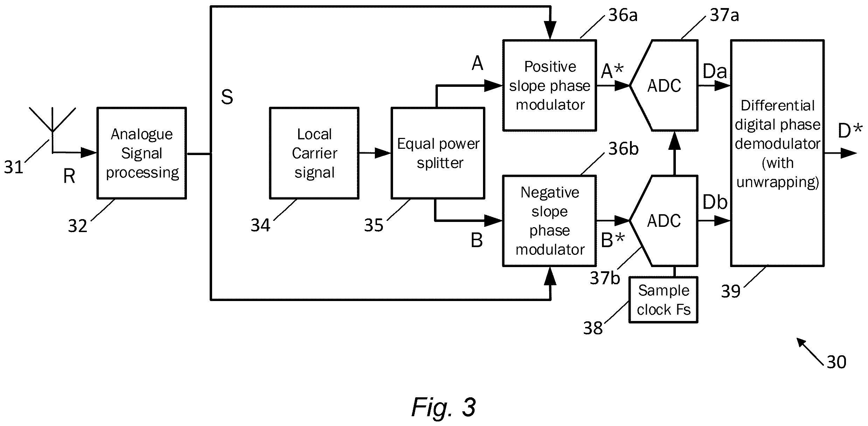

Figure 3 is a block diagram of a receiver circuit, indicated generally by the reference numeral 30, in accordance with an example embodiment. The receiver circuit 30 comprises an antenna 31 (similar to the antenna 12 discussed above), an analogue signal processing circuit 32 (similar to the analogue signal processor 14 discussed above), a local carrier signal generator 34, a power splitter 35, a first (positive slope) phase modulator 36a, a second (negative slope) phase modulator 36b, a first analogue-to-digital converter (ADC) 37a, a second analogue-to-digital converter (ADC) 37b, and a differential digital phase demodulator 39. The ADCs 37a and 37b receive a clock signal from a clock circuit 38.

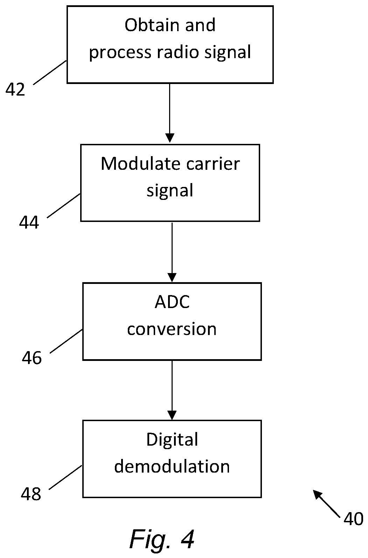

Figure 4 is a flow chart, indicated generally by the reference numeral 40, showing an example operation of the circuit 30.

The algorithm 40 starts at step 42, where radio signals R received at the antenna 31 are subject to analogue signal processing by the signal processor 32 to form an antenna-derived signal S. The step 42 is therefore similar to the step 22 of the algorithm 20 described above.

The signal S is provided as an input to the first and second phase modulators 36a and 36b. The signal processor 32 may include any, none or multiples of: a pre-selection filter, an attenuator (which may be variable), a low noise amplifier, a mixer stage fed by a local oscillator, an intermediate frequency filter, etc. The signal processor 32 may seek to select the part of the radio spectrum of interest and to reject (or at least suppress) unwanted signals on the basis of frequency. Thus, the signal S may be referred to as the "wanted" part of the signal received at the antenna (and is sometimes referred to herein as the "antenna-derived signal").

The local carrier signal generator 34, which may be a fixed frequency oscillator, generates a local carrier signal that is split (e.g. evenly split using power splitter 35) to feed carrier signal inputs A and B of the first and second phase modulators 36a and 36b respectively.

At operation 44, the carrier signals A and B are modulated by the first and second phase modulators 36a and 36b respectively, based on the antenna-derived signal S, to generate phase modulated outputs signals A* and B* respectively. Thus, the output signals A* and B* are phase modulated products of the local carrier signal. As discussed in detail below, the first phase modulator 36a has a positive phase-voltage slope and the second phase modulator 36b has a negative phase-voltage slope.

The first and second phase modulators 36a, 36b may be configured to output nominally the same magnitude of phase signal change for the same antenna-derived signal, but with different sign. Note that although the outputs may be "nominally equal" in magnitude, exact equality may not be possible, for example due to device tolerances. Thus, the magnitudes may be similar or nearly equal in magnitude, rather than having mathematically identical magnitudes.

At operation 46, the phase modulated signals A* and B* are digitised by the ADCs 37a and 37b respectively to produce digital signals Da and Db. The ADCs have a common sample clock at frequency Fₛ. The sampling frequency Fₛ may be selected to be high enough to capture the phase modulated signals. Note that the sampling frequency Fₛ may be significantly higher than required in a conventional receiver due to the additional bandwidth of the modulated signals. Moreover, the local carrier frequency (the output of the local carrier signal generator 34) may be at the centre of one of the ADC Nyquist bands (such as Fₛ/4 or 3Fₛ/4, for example).

Finally, at operation 48, the differential digital phase demodulator 39 performs phase demodulation to generate a digital output D* based on the digital signals Da and Db, as discussed in detail below. D* could be subject to further processing to extract a payload, as in some known receivers.

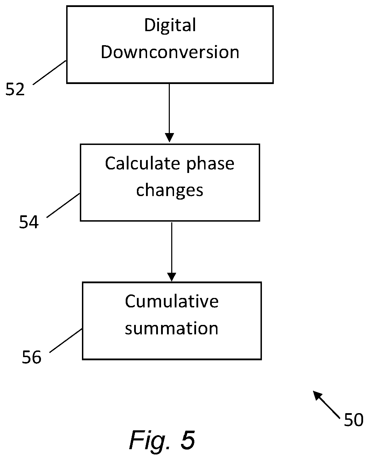

Figure 5 is a flow chart, indicated generally by the reference numeral 50, showing functionality of an example demodulator (e.g. the differential digital phase demodulator 39) in accordance with an example embodiment. Thus, the flow chart 50 shows an example implementation of step 48 of the algorithm 40.

The algorithm 50 starts at step 52, where the digital signals Da and Db are downconverted. Specifically, a first digital downconverter is provided to generate in-phase and quadrature products of the first digital signal and a second digital downconverter is provided to generate in-phase and quadrature products of the second digital signal. In one example embodiment, a digital downconverter is implemented by mixing/multiplying the digitised signal with a quadrature pair of sinusoids represented numerally. The sinusoids may be at the relevant carrier frequency (i.e. the local carrier signal as output by the local carrier signal generator 34) when represented by the ADC sample rate. The product of the multiplication is low pass filtered to isolate the components at the difference frequency between the incoming signal and the carrier sinusoids and exclude the components at the sum frequency.

At step 54, a processing module is used to determine phase angle changes between successive samples of the in-phase and quadrature outputs from the downconversion of the first and second digital signal respectively, wherein the digital output is based on the determined changes. The phase changes are expressed within the angular range of -π to +π radians. If the process results in angles outside of this range, the values may be coerced to lie within the range -π to +π by adding or subtracting 2π as necessary.

At step 56, a cumulative summation module generates a sample-by-sample cumulative summation of phase changes; thus, total phase changes over multiple samples can be determined. A digital output of the algorithm 50 is based on cumulative summation.

A phase change calculator may be used to calculate changes between consecutive samples of in-phase and quadrature products from the downconversion of the first and second digital signals respectively that is used by the cumulative summation module in step 56. As discussed in detail below, the phase change calculator may comprise a subtractor configured to subtract calculated phase changes of samples of one of the first and digital signals from corresponding samples of the other of said first and second digital signals. Note that the first and second streams of phase change data may be coerced to remains within ±π radians; the subtractor may simply subtract the data received.

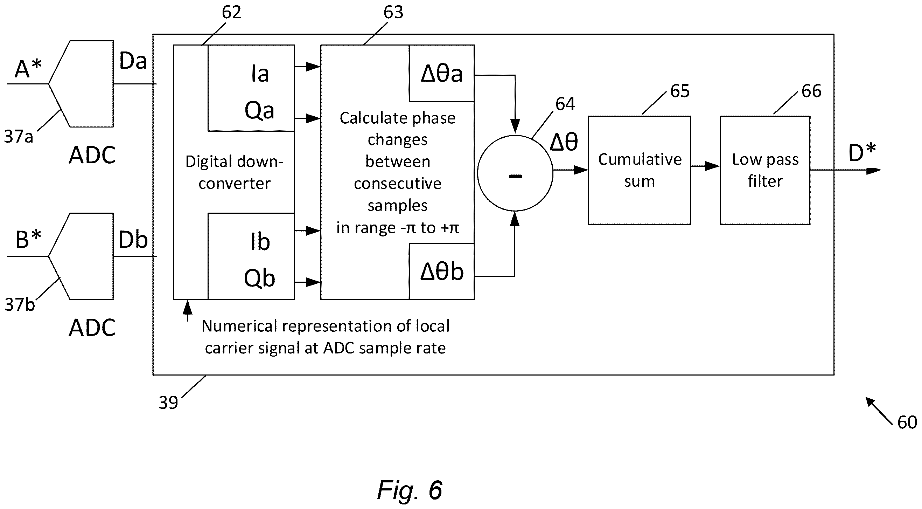

Figure 6 is a block diagram of a digital demodulator circuit, indicated generally by the reference numeral 60, in accordance with an example embodiment. The digital demodulator circuit 60 includes the first and second ADCs 37a and 37b and the differential digital phase demodulator 39 described above and may be used to implement the algorithm 50 described above.

As shown in Figure 6, the example implementation of the differential digital phase demodulator 39 comprises a digital down-converter module 62, a phase change calculation module 63, a subtraction module 64, a cumulative summing module 65 and a filter 66.

The outputs Da and Db of the ADCs 37a and 37b are down-converted using a complex digital downconverter (the digital down-converter module 62) in which the incoming data are multiplied by a complex (i.e. sine and cosine) numerical oscillator at the carrier frequency when represented by the ADC sample rate Fₛ. The local carrier frequency may be the frequency of the signal output by the local carrier signal generator 33 discussed above - note that the demodulator 39 may know the carrier frequency in advance or may be required to determine the carrier frequency in use. The multiplier in-phase and quadrature products are the filtered outputs of the downconversion process providing the complex baseband signals I and Q (labelled Ia, Qa, Ib and Qb in Figure 6).

The phase change calculation module 63 calculates phase modulation changes between consecutive samples. The phase angle of any I, Q sample (as output by the digital downconverter module 62) can be calculated using trigonometry, for example using a coordinate rotation digital computer (CORDIC) algorithm. For each ADC path, a data stream is created containing the angular change between consecutive I, Q sample pairs. This contains the phase modulation changes Δθa and Δθb recovered from A* or B* over each output sample time period of the downconverter. The mathematics ensures than these values range over no more than ±π radians.

By using the subtractor module 64 to take the difference Δθ = Δθa - Δθb, both data streams are combined into a new stream of phase changes which should be equal to ~ 2Δθa since both modulators have (approximately) equal magnitude but inverse characteristics. Δθ ranges over no more than ±2π radians. All further processing treats Δθ as a time series of signal voltage changes, rather than angles, which are added as signed numbers with no limit in range.

The cumulative summing module 65 generates a sample-by-sample cumulative sum of Δθ to produce a representation of the original modulating signal S as a time series. This can be low pass filtered (using filter 66) to exclude unwanted frequencies and resampled to a convenient data rate commensurate with the wanted input signal bandwidth. This is the output D* discussed above, which may be processed further as in a standard receiver as required.

It is noted that aspects of the differential digital phase demodulator 39 may be implemented in various mathematically equivalent ways. For example, when forming the Δθa and Δθb data streams, it may be convenient to form the product of the latest I,Q pair with the complex conjugate of the previous I,Q pair and perform a trigonometric operation on the result to reveal a difference phase angle.

Features of example implementations of the receiver architecture discussed above include the following:
- The power of the signals A* and B* reaching the ADCs 37a, 37b is not dependent on the signal power in S. Instead, A* and B* become increasingly modulated in phase as the signal power rises, whilst the power envelope is effectively constant. The ADC input levels can, therefore, be set at an optimal value.
- Components of amplitude noise in the ADC signals are substantially rejected by the digital processing which only looks for phase information.
- Phase noise added from the local carrier signal source will be common to Δθa and Δθb and will subtract when forming Δθ.
- Clock jitter on the sampling clock at Fs will affect both ADCs. In as much as the signals A* and B* have common components, there will be a degree of cancellation when forming Δθ.
- Non-linearity in the phase modulator responses may be partially compensated since the Δθ = Δθa - Δθb values used in the demodulation are the result of the combined response of opposite phase modulators to the same modulation input signal.

The sensitivity of the receiver is a function of the self-noise and gain of the analogue signal processor 32 (ASP gain), the modulator transfer function in radians per volt, and the ADC noise.

The maximum signal handling of the receiver is a function of the ASP gain, the modulator transfer function from S to A* or B*, the bandwidth of the ADCs, and the sampling clock Fₛ.

In order to handle high amplitude inputs with a high sensitivity, the phase modulator transfer function should be both high in radians per volt, and typically sustained over several volts of input signal S. This means that the phase modulator output phase range should extend over multiple phase cycles. For example, a modulator with a transfer function of 5 radians per volt and an expected input voltage range of +/-2V would be required to shift phase over a total range of +/- 10 radians.

Analysis shows that a large ratio between the ADC digital bandwidth and the maximum wanted signal frequency supports the use of phase modulators with a large modulation transfer function.

By way of example, microwave ADCs with sample clocks of several GHz would support high frequency receiver (HF) operation using phase modulators with a modulation response in excess of 5 radians per volt. Such modulators promise operation at good sensitivity with modest or no ASP gain whilst simultaneously handling large input signals. Such large modulation responses are not trivial to implement.

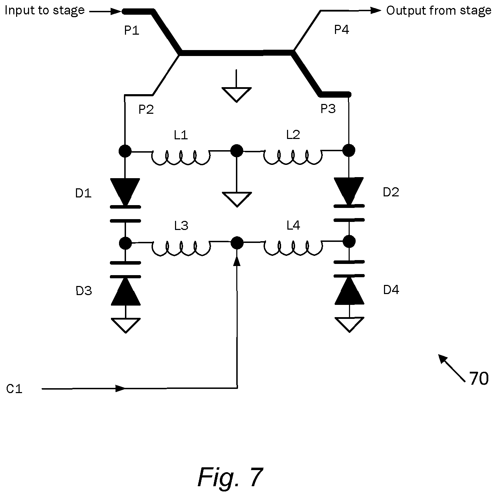

Figure 7 is a block diagram of a phase modulator circuit, indicated generally by the reference numeral 70. The phase modulator circuit 70 is a phase shifter or phase modulator based on a 4-port quadrature hybrid coupler, which is designed for a certain frequency range and characteristic impedance. The frequency range of the phase modulator circuit 70 includes the local carrier frequency described above. As discussed in detail below, the phase modulator circuit 70 is a building block of an example implementation of the phase modulators 36a and 36b discussed above.

The quadrature hybrid coupler 70 is formed from a pair of electromagnetically coupled transmission lines, where the coupled length is a quarter wavelength at the design frequency. It is noted that other forms of 4-port quadrature hybrid coupler may be used based on, for example, transformers or inductors with capacitors. The optimum hybrid coupler to use may, for example, be dependent on the frequency range over which the hybrid coupler is required to operate.

In the phase modulator circuit 70, a signal from a designated input port (P1) is divided equally in power between two so-called output ports (P2 and P3, which are notionally 90 degrees apart in phase). If the impedance at the output ports is not equal to the characteristic impedance of the coupler, signal power is reflected from the output ports to recombine at the fourth port (P4), often designated the isolation port. In a phase shift application, the characteristic impedance of the quadrature hybrid coupler is designed to match that of the input signal source and the load at the isolation port. The isolation port P4 is used as the output of the phase shifter.

Equal reflective loads are placed at the so-called output ports. Reflective loads may be inductors, shorted or open transmission lines, capacitors, or a combination thereof.

In the phase modulator circuit 70, the phase shift at reflection depends on the type and value of the reflective loads and determines the phase shift from input port to isolation port.

Equal voltage-variable shunt capacitors at ports P2 and P3 provide a means of controlling the phase-shift between input and isolation ports. In the example phase modulator circuit 70, varactor diodes (D1, D2, D3 and D4) are used as voltage variable capacitors. D3 and D4 are connected to ground as indicated in Figure 7.

Since the input and isolation ports are matched to the same characteristic impedance, it is possible to cascade phase shifters efficiently, as discussed further below.

An input signal feeds the input port P1. The output signal from port P4 is a phase-shifted version of the input signal, typically with little power loss.

The nominally identical variable capacitance diodes series pairs D1, D3 and D2, D4 act as reflective loads on ports P2 and P3. The capacitance of the diodes determines the phase shift of the reflection and hence the phase of the output at P4. The variable capacitance diodes may have nominally identical capacitances or may have values that are matched (or approximately matched) in some way.

Inductors L1, L2, L3 and L4 may be selected to have a higher impedance than the diode capacitances at the carrier frequency, but a low impedance at the lower control voltage frequency.

The diode capacitances may be selected such that they effect a typical phase shift of about 90 degrees over their control voltage range, which may be several volts.

The control voltage (C1) reverse biases the diodes. The diode pairs may be either anode to anode or cathode to cathode. The sense of the phase shift with control voltage is determined by whether the diode pairs are arranged as anode to anode or cathode to cathode.

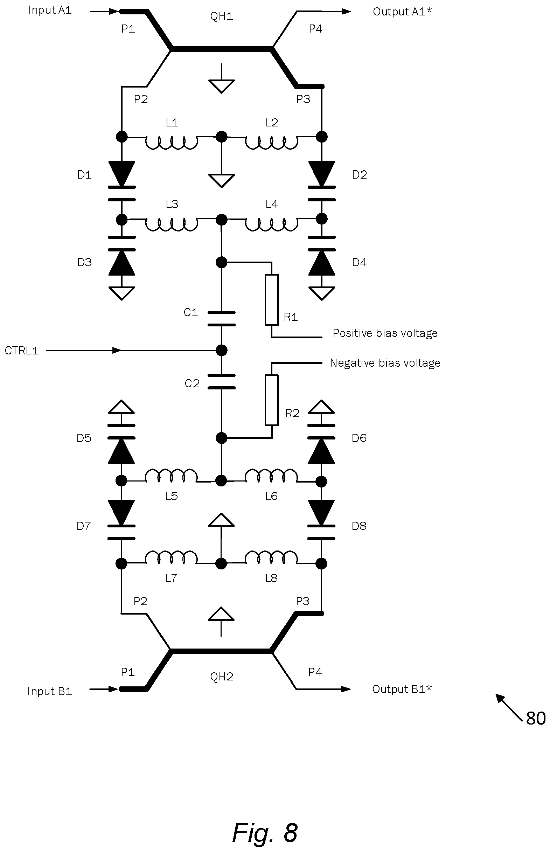

Figure 8 is a block diagram showing a pair of phase modulator circuits, indicated generally by the reference numeral 80, in accordance with an example embodiment. The pair of phase modulator circuits 80 includes two input signals (A1, B1), two output signals (A1*, B1*) and a common control voltage (CTRL1). In a radio receiver application, the control voltage (CTRL1) is an alternating signal with no DC content.

The identical (or close to identical, e.g. to within device tolerances) diode pairs between the upper signal path A1 to A1* and those in the lower signal path B1 to B1* are reversed such that the phase modulation sense between the two paths is inverse with respect to the control voltage (and can therefore be used to implement the positive- and negative-slope phase modulators described above).

The control voltage (CTRL1) is supplied to each of the pair of modulators through series capacitors C1 and C2 respectively, so that bias voltages may be applied via resistors R1 and R2 to keep the diode pairs reverse biased and centred on a chosen operating point. In one modulator, the bias voltage is positive. In the other the bias voltage is an equal magnitude negative voltage (or at least approximately equal). C1 and C2 are equal (or approximated equal) in value and of much lower impedance at the control voltage frequency than the maximum combined parallel capacitances of any four diodes.

Thus, the variable capacitance diodes of each first phase modulator of the circuit 80 have an opposite polarity to corresponding variable capacitance diodes of each second phase modulator.

A bias control input is provided for each variable capacitance diode to control reverse biasing of said variable capacitance diodes. The variable capacitance diodes are thereby reverse biased at a central value allowing for the control signal voltage to remain within the normal operating range of the diodes.

The resistances R1 and R2 have impedances that are high compared to C1 and C2 at the control voltage frequency and low enough to pass the combined reverse leakage current of the diodes whilst maintaining the dc operating point of the diodes. Biases may alternatively be supplied via high value inductors or resistor inductor combinations.

It is noted that the control port impedance of the modulator pair shown in Figure 8 with respect to the modulator ground will appear capacitive with an approximate value equal to the operating point capacitance of eight variable capacitance diodes. This capacitance has a weak dependence on the control voltage since half of the diode capacitances increase and half decrease as the control voltage rises or falls about its centre value.

As noted above, it is possible to cascade phase shifters such as the pair of phase modulator circuits 80 in order to increase the total amount of phase shift (i.e. the phase difference between the input A and the output A* and the phase difference between the input B and the output B*).

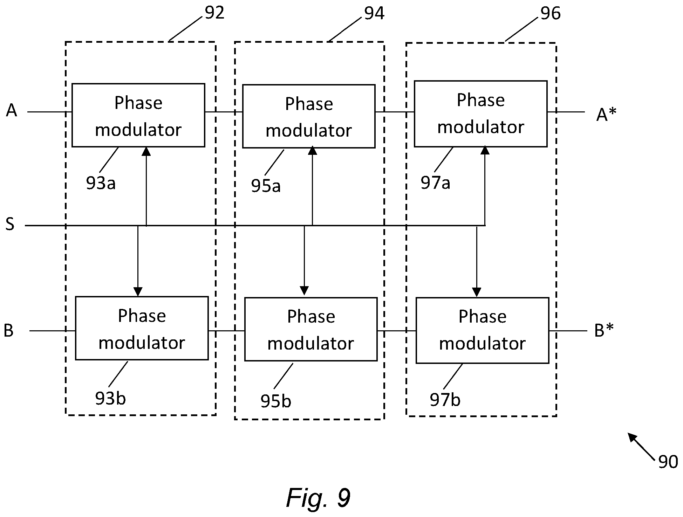

Figure 9 is a block diagram of a phase modulator circuit, indicated generally by the reference numeral 90, in accordance with an example embodiment. The phase modulator circuit 90 may be used to implement the phase modulator circuits 36a and 36b described above.

The phase modulator circuit 90 comprises first, second and third phase modulator pairs arranged in series, indicated by the reference numerals 92, 94 and 96 respectively; each modulator pair may be formed from an instance of the pair of phase modulator circuits 80 described above. Note that three phase modulator pairs are shown by way of example only, more or fewer phase modulator pairs could be provided (typically more). As discussed below, the phase modulator pairs may be implemented using the pair of phase modulator circuits 80 described above.

The first phase modulator pair 92 includes a first phase modulator 93a and a second phase modulator 93b, each having a first input, a second input and an output. Similarly, the second phase modulator pair 94 includes a first phase modulator 95a and a second phase modulator 95b (each having a first input, a second input and an output), and the third phase modulator pair 96 includes a first phase modulator 97a and a second phase modulator 98b (each having a first input, a second input and an output).

The first input of the first phase modulator 93a of the first phase modulator pair 92 is coupled to a carrier signal input (A) of the apparatus (e.g. the local carrier signal output by the local carrier signal generator 34 of the receiver circuit 30 described above) and the first input of the first phase modulators 95a, 97a, of the other phase modulator pairs are coupled to the output of the preceding first phase modulator.

The first input of the second phase modulator 93b of the first phase modulator pair 92 is coupled to the carrier signal input (B) of the apparatus and the first input of the second phase modulators 95b, 97b of the other phase modulator pairs are coupled to the output of the preceding second phase modulator.

The second input of each first and second phase modulator is coupled to a radio signal input (S) of the apparatus (e.g. the antenna-derived signal output by the analogue signal processing circuit 32 of the receiver circuit 30 described above).

The outputs of the first and second phase modulators of the last phase modulator pair (the phase modulator pair 96 in the example shown in Figure 9) are coupled to first and second outputs (A*, B*) of the phase modulator circuit 90 respectively. Thus, in use, the first and second outputs of the phase modulator circuit 90 provide first and second phase modulated carrier signals respectively that are modulated based on the radio signal S. Note that providing a plurality of phase modulator pairs in series enables the phase difference at the output to be increased by a factor dependent on the number of pairs in the plurality.

Each first phase modulator 93a, 95a, 97a comprises a phase shift circuit for phase shifting a signal at the respective first input based on a signal at the respective second input, wherein the phase shift is dependent on the capacitance of variable capacitance diodes of the respective first phase modulator. As discussed above, said capacitance is dependent on the signal received at the second input. Note that each first phase modulator has a positive phase-voltage slope.

Similarly, each second phase modulator 93b, 95b, 97b further comprises a phase shift circuit for phase shifting a signal at the respective first input based on a signal at the respective second input, wherein the phase shift is dependent on the capacitance of variable capacitance diodes of the respective second phase modulator. The capacitance is dependent on the signal received at the second input. Note that the second phase modulator has a negative phase-voltage slope.

The first and second phase modulators of each phase modulator pair typically produce the same nominal magnitude of phase signal change for the same signal on the third input, but with different sign. Note that although the outputs may be "nominally equal" in magnitude, exact equality may not be possible, for example due to device tolerances. Thus, the magnitudes may be similar or nearly equal in magnitude, rather than having identical magnitudes.

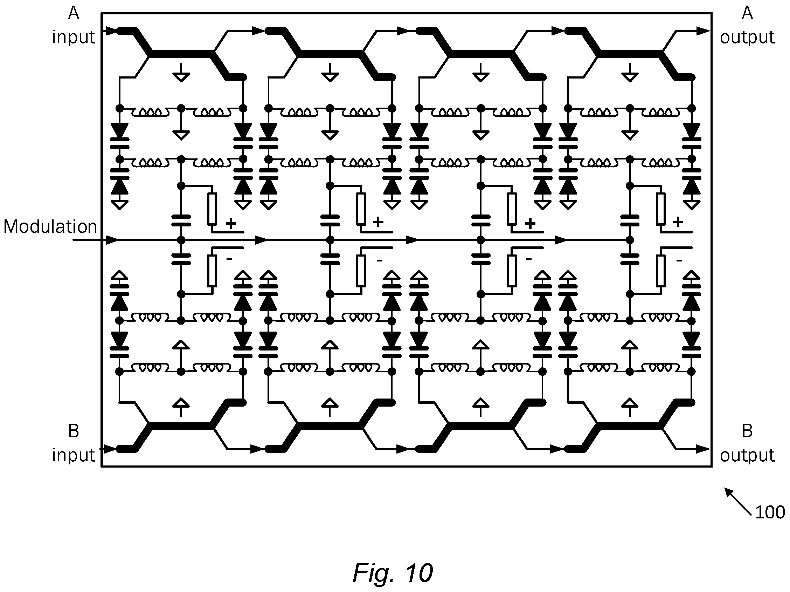

Figure 10 is a block diagram of a phase modulator circuit, indicated generally by the reference numeral 100, in accordance with an example embodiment. The phase modulator circuit 100 is an example implementation of the phase modulator circuit 90 described above with reference to Figure 9, in which each of the pair of phase modulator circuits of the circuit 90 is implemented using the pair of phase modulator circuits 80 described with reference to Figure 8. Note that the phase modulator circuit 100 differs from the phase modulator circuit 90 in that four pairs of phase modulator circuits are provided (rather than three as in the phase modulator circuit 90).

The phase modulator circuits 90 and 100 enable much greater phase shifts than can be achieved with a single phase modulator pair and with a larger transfer function of radians-per-volt. For example, in the phase modulator circuit 100, the total phase shift is four times larger than for a single stage and the transfer function in radians per volt is also four times larger.

In the phase modulator circuits 90 and 100, the phase shift stages are cascaded for the modulated signal paths such that further phase shifts are added along the cascade, while the modulation input is common. It is noted that the bias resistors and capacitors may be shared between stages with the same diode polarity if convenient. The modulation input capacitance of the phase modulator circuit 100 is about 32 times the midpoint capacitance of a single variable capacitance diode.

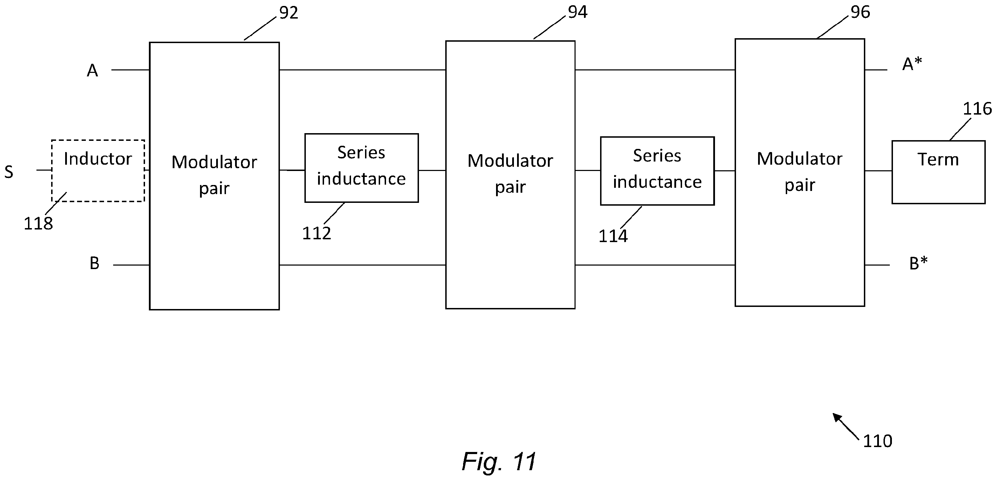

Figure 11 is a block diagram of a phase modulator circuit, indicated generally by the reference numeral 110, in accordance with an example embodiment.

The phase modulator circuit 110 includes the first, second and third phase modulator pairs 92, 94, 96 of the phase modulator circuit 90 described above. As noted above, three phase modulator pairs are shown by way of example only, more or fewer phase modulator pairs could be provided (typically more).

Carrier signal inputs (A and B) are provided to the first modulator pair 92 of the plurality and first and second outputs (A* and B*) are provided by the last modulator pair 96 of the plurality. The first and second output provide first and second phase modulated carrier signals respectively that are modulated based on a radio signal S.

As discussed above, the antenna-derived signal S is provided to each of the modulator pairs. Specifically, in the phase modulator circuit 110, a transmission line is provided to connect the second input of each phase modulator of the plurality to the second input of each neighbouring phase modulator of the plurality.

The transmission line includes series inductances 112 and 114 and a termination circuit 116. The inductances are provided to connect the second input of each phase modulator of the plurality to the second input of each neighbouring phase modulator of the plurality. The series inductances 112, 114 each form a lumped impedance inductor-capacitor transmission line in conjunction with the shunt capacitance of the modulator control port impedance. The termination circuit 116 may be a resistance selected to match a characteristic impedance of the transmission line (e.g. 50 ohms).

The characteristic impedance of the L-C lumped impedance transmission line so formed is determined by the series inductor values and the shunt capacitance of the phase modulator control ports. In addition, the velocity factor of the lumped impedance transmission line so formed is determined by the series inductor values and the shunt capacitance of the phase modulator control ports.

A further inductor 118 may also be provided as the first element of the L-C transmission line to connect the input S to the first modulator control port. In addition, a further series inductor may be provided before the resistive termination 116.

The inductances in the system 110 may be selected such that the characteristic impedance of the lumped impedance transmission line is convenient to the overall system (e.g. proportional to square root of L divided by C, wherein L is the inter-stage series inductance and C is the stage shunt capacitance). This will fix the velocity factor (inversely proportional to square root of the product LC).

By forming a transmission line as described above, the input port receiving the signal S can be configured to "see" a resistive load rather than a large capacitive load, which extends its bandwidth. The inductance values may be selected to make the characteristic impedance of the transmission line match closely that of the modulating source.

The antenna-derived signal S received at the input of a phase modulator circuit in accordance with the principles described herein (such as the phase modulator circuits 90, 100 and 110) experiences delays as it is transferred to successive modulator pairs of the plurality of modulator pairs. In some example embodiments, it may be advantageous to introduce additional compensating delays into the modulated signal paths that pass through the modulator pairs.

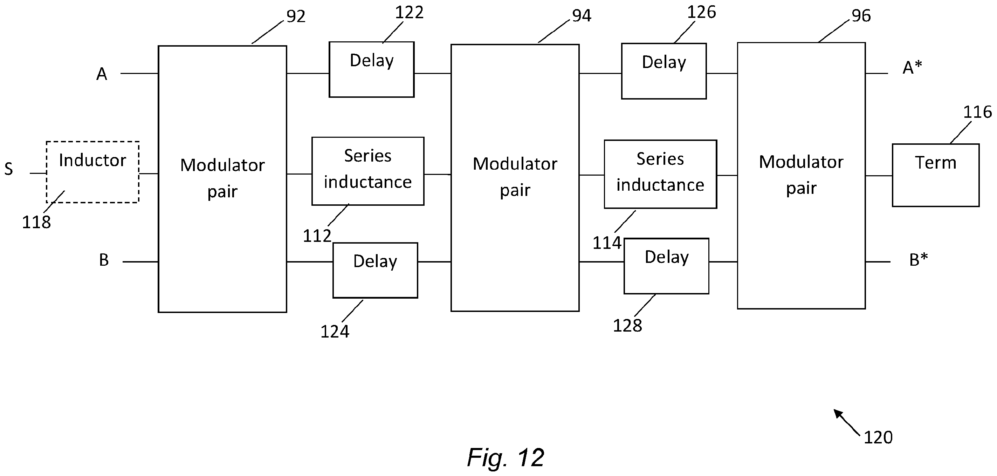

Figure 12 is a block diagram of a phase modulator circuit, indicated generally by the reference numeral 120, in accordance with an example embodiment. The phase modulator circuit 120 includes the first, second and third phase modulator pairs 92, 94, 96 of the phase modulator circuits 90 and 110 and also includes the inductance and termination circuits 112, 114 and 116 of the phase modulator circuit 110. As noted above, three phase modulator pairs are shown by way of example only, more or fewer phase modulator pairs could be provided (typically more).

The phase modulator circuit 120 (in common with the phase modulator circuit 110) includes a transmission line that is provided to connect the second input of each phase modulator of the plurality to the second input of each neighbouring phase modulator of the plurality. The transmission line includes the series inductances 112 and 114 and the resistive termination 116.

The phase modulator circuit 120 further comprises a first delay circuit 122, a second delay circuit 124, a third delay circuit 126 and a fourth delay circuit 128. The first delay circuit 122 couples the output of the first phase modulator of the first modulator pair 92 to the input of the first phase modulator of the second modulator pair 94. The second delay circuit 124 couples the output of the second phase modulator of the first modulator pair 92 to the input of the second phase modulator of the second modulator pair 94. The third delay circuit 126 couples the output of the first phase modulator of the second modulator pair 94 to the input of the first phase modulator of the third modulator pair 96. The fourth delay circuit 128 couples the output of the second phase modulator of the second modulator pair 94 to the input of the second phase modulator of the third modulator pair 96.

It is not essential to all example embodiments that delay circuits are provided between each modulator pair as shown in Figure 12. In general terms, delays may be added, as necessary, so that the overall delays experienced by modulated carrier signals (introduced by the delay circuits) are similar to delays experienced by the modulating signal (the radio signal input) as is passes along the transmission line.

By way of example, the delay circuits may include: one or more first delay circuits coupling at least some (e.g. all) of the outputs of the first phase modulators and the first inputs of the next first phase modulator of the plurality; and one or more second delay circuits coupling at least some (e.g. all) of the outputs of the second phase modulators and the first inputs of the next second phase modulator of the plurality.

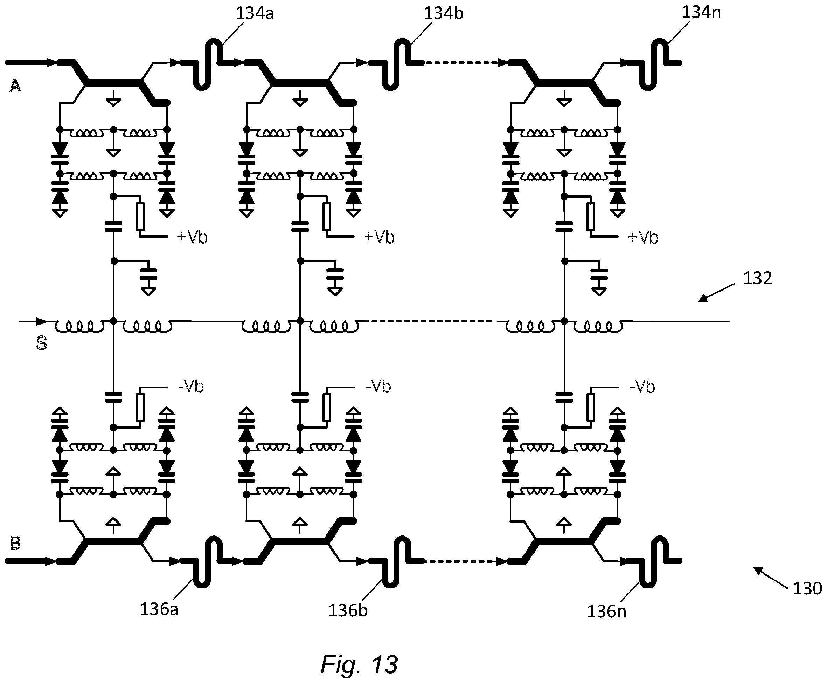

Figure 13 is a block diagram of a phase modulator circuit, indicated generally by the reference numeral 130, in accordance with an example embodiment. The phase modulator circuit 130 is an example implementation of the phase modulator circuit 120 described above with reference to Figure 12, in which each of the pair of phase modulator circuits of the circuit 130 comprises the pair of phase modulator circuits 80 described with reference to Figure 8, a transmission line formed from a plurality of lumped inductors (indicated generally by the reference numeral 132), and a plurality of delay circuits 134, 136. Note that the transmission line of the phase modulator circuit 130 may additionally include a termination resistor (not shown in Figure 13). Where pairs of inductors are provided in series, these could, of course, be replaced by a single inductor.

As with the phase modulator circuits 90, 100 and 120, the phase shift stages of the phase modulator circuit 130 are cascaded (n stages are shown in Figure 13) for the modulated signal paths such that further phase shifts are added along the cascade, while the modulation input is common. As the number of stages in the cascade of phase shifters increases, the control port capacitance may become too large to support the required modulating input frequency as the number of stages within the cascade is increased. In the system 130, the series inductive elements and optional additional shunt capacitors of the transmission line 132 can be used to provide sections of a lumped impedance transmission line matched in impedance to the modulation source.

The phase modulator circuit includes a plurality of first delay circuits 134a, 134b... 134n coupling the first outputs of the first phase modulators and the first inputs of the next first phase modulator of the plurality and a plurality of second delay circuits 136a, 136b... 136n coupling at least some of the second outputs of the second phase modulators and the second inputs of the next second phase modulator of the plurality. As noted above, it is not essential to all example embodiments that delay circuits are provided between each phase modulator pair of the plurality as shown in Figure 13.

The delay circuits 134a-134n and 136-136n are implemented using a serpentine connector track with a characteristic impedance matched to that of the modulated signal path. Such a track introduced a physical detail to the passage of the modulated carrier signals. Of course, the delay circuits could be implemented in many other ways (for example using lumped components).

The transmission line 132 is typically terminated at its far end with a resistor (not shown) to match its impedance and to minimise reflections. The modulation input impedance is now defined by the transmission line impedance rather than the bulk capacitance of the combined phase-shifter stages. When two inductive elements are in series they may be combined into a single element. The inductors, in conjunction with the combined capacitance of a shunt capacitor and the capacitance seen at the input to the modulation stages between inductors, determine the transmission line impedance and its group delay. The delay circuits 134a-134n and 136-136n can be used to seek to equalise the group delay along the modulated signal paths with the group delay experienced by the modulating signal. The degree of delay equalisation between modulated and modulating signal may, for example, be less than about one eighth of the period of the highest modulating signal frequency over the total length of the phase-shifter cascade.

The phase modulator circuits 90, 100, 110, 120 and 130 all include a cascade of phase shifters. There will be some loss of modulated signal power over the cascade of phase-shifters. In some example embodiments, signal levels along the cascade may be maintained by inserting one or more amplifiers between at least some of the phase-shifter stages and to drive the ADCs. These amplifiers may exhibit low added phase noise and may operate in amplitude compression.

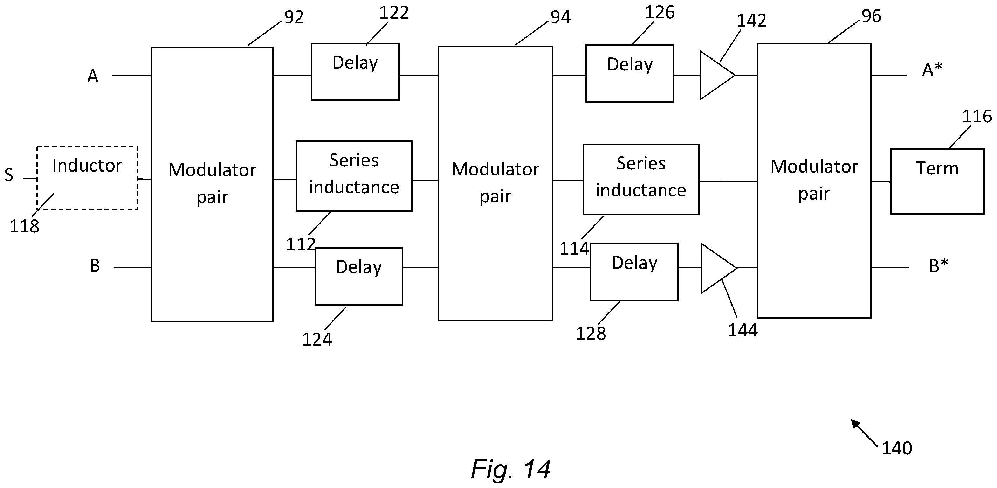

Figure 14 is a block diagram of a phase modulator circuit, indicated generally by the reference numeral 140, in accordance with an example embodiment. The phase modulator circuit 140 includes the first, second and third phase modulator pairs 92, 94, 96 of the phase modulator circuits 90, 110 and 120 and also includes the series inductances and resistive termination 112, 114 and 116 and the delay circuits 122, 124, 126 and 128 described above.

The phase modulator circuit 140 additionally includes first and second amplifiers 142 and 144 coupling carrier signal outputs of the second phase modulator 94 to inputs of the third phase modulator 96. Note that although only two amplifiers are shown in Figure 14, further amplifiers may be provided between at least some other modulator pairs.

It should also be noted that although amplifiers are shown in the phase modulator circuit 140 in combination with delay circuitry, this is not a requirement of all example embodiments. For example, similar amplifiers could be added to the phase modulator circuits 90, 100 and 110 described above, in which delay circuitry is not provided. Moreover, the number of amplifiers provided may be different that shown. By way of example, one amplifier may be provided for each 10 phase shifters.

The phase modulator circuits 110, 120 and 140 each include a plurality of modulator pairs 92, 94 and 96. Each of the modulator pairs 92, 94 and 96 may comprise a phase modulator circuit 100 (or a similar phase modulator) which omits inductance in the modulation input signal line. Thus, phase modulator circuits may be formed in groups of a plurality of phase modulators (e.g. groups of four), with inductances (and shunt capacitances) provided between the groups.

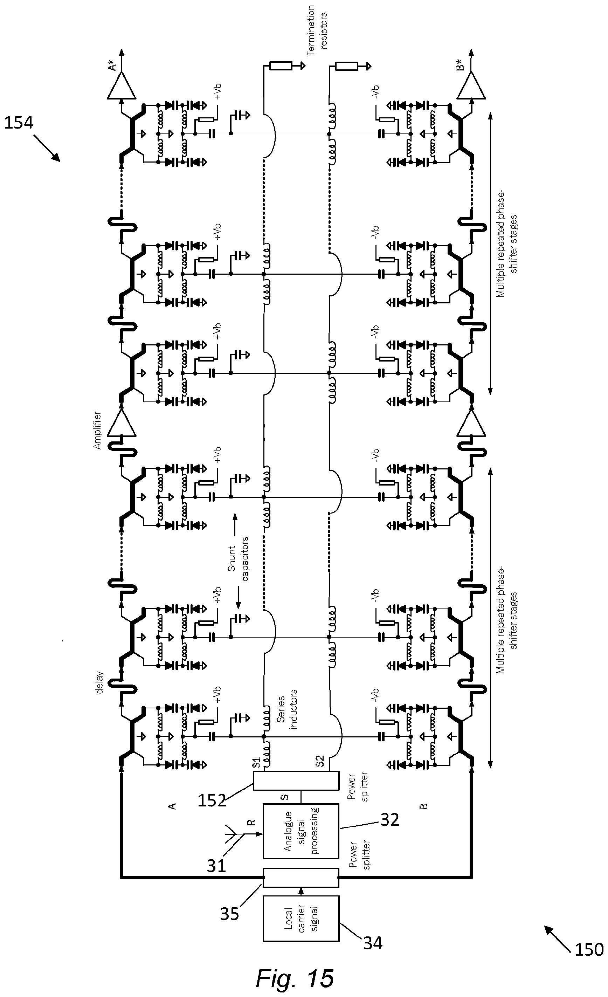

Figure 15 is a block diagram of a receiver circuit, indicated generally by the reference numeral 150, in accordance with an example embodiment.

The receiver circuit 150 includes the antenna 31, the analogue signal processing (ASP) circuit 32, the local carrier signal generator 34 and the power splitter 35 of the receiver 30 described above. The receiver circuit 150 also includes a phase modulator circuit 154 that is similar to the phase modulator circuit 140 described above. The phase modulator circuit 154 includes the delay circuits and amplifiers of the phase modulator circuit 140, but some or all of these may be omitted in some example embodiments.

In the embodiments described above, the antenna-derived signal S feeds the second input of first and second phase modulators of multiple phase modulator pairs, which may be arranged in the form of a series inductor shunt capacitor lumped impedance transmission line terminated with a resistor. In the modified arrangement shown in FIG. 15, the signal S feeds an equal power splitter 152 yielding two outputs S1 and S2. Each of S1 and S2 feed the second input of first and second modulators of multiple phase modulator pairs, which may also each form separate terminated transmission lines. The phase modulator pairs fed by S1 would alternate with those fed by S2 along the phase modulator cascade.

An advantage of providing a pair of transmission lines is that, for the same total phase modulation range, the total propagation time for the modulating signal is approximately halved. This may be important when matching delays between the modulated and modulating signals.

The transfer function in radians per Volt from S to the signals reaching the ADC inputs is reduced in this arrangement, but the maximum operating voltage range of S likely to be increased.

It is noted that certain types of power splitter, such as transformers, could invert the phase of S2 compared to S1. In this case it would be possible to swap the phase-voltage slopes within alternate phase modulator pairs by swapping the diode polarities and biases to restore the correct overall modulator response.

In principle it would be possible to feed S into a power splitter with more than two outputs along with an equal number of transmission lines.

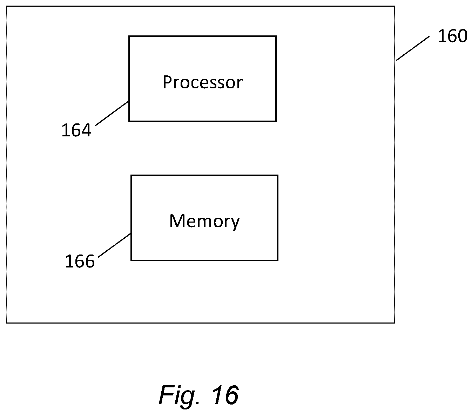

Figure 16 shows a system 160 (comprising a memory 166 and processor 164) that can be used in implementations of example embodiments. The processor 164 may store a computer program for implementing aspects of one or more of the algorithms described herein (such as the algorithms 20, 40 or 50 described above). In practice, the processor 164 is likely to be a digital signal processor (DSP) including processing blocks such as multipliers, adder/subtractors, and storage registers. The processing may be performed in parallel using pipelines and local registers to enable a high processing rate and data throughput.

Embodiments of the components described herein can be implemented using any suitable software, hardware or firmware applications, programming language, data editors, etc., and may be represented/stored/processed using any suitable data structures, and so on.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. An apparatus comprising a plurality of phase modulator pairs arranged in series, each phase modulator pair comprising a first phase modulator and a second phase modulator, each having a first input, a second input and an output, wherein:
the first input of the first phase modulator of the first phase modulator pair of the plurality is coupled to a carrier signal input of the apparatus and the first input of the first phase modulators of the other phase modulator pairs are coupled to the output of the preceding first phase modulator of the plurality;
the first input of the second phase modulator of the first phase modulator pair of the plurality is coupled to the carrier signal input of the apparatus and the first input of the second phase modulators of the other phase modulator pairs are coupled to the output of the preceding second phase modulator of the plurality;
the second input of each first and second phase modulator is coupled to a modulation signal input of the apparatus;
the outputs of the first and second phase modulators of the last phase modulator pair of the plurality are coupled to first and second outputs of the apparatus respectively;
each first phase modulator of the plurality further comprises a phase shift circuit for phase shifting a signal at the respective first input based on a signal at the respective second input, wherein the phase shift is dependent on the capacitance of variable capacitance diodes of the respective first phase modulator, said capacitance being dependent on the signal received at the second input, wherein the first phase modulator has a positive phase-voltage slope; and
each second phase modulator of the plurality further comprises a phase shift circuit for phase shifting a signal at the respective first input based on a signal at the respective second input, wherein the phase shift is dependent on the capacitance of variable capacitance diodes of the respective second phase modulator, said capacitance being dependent on the signal received at the second input, wherein the second phase modulator has a negative phase-voltage slope.

2. The apparatus according to claim 1, wherein the first phase modulator and the second phase modulator of each phase modulator pair produce the same nominal magnitude of phase signal change for the same signal on the third input, but with different sign.

3. The apparatus according to claim 1 or claim 2, further comprising:
a transmission line connecting the second input of each phase modulator of the plurality to the second input of each neighbouring phase modulator of the plurality; or
a pair of transmission lines, a first transmission line of the pair connecting together the second inputs of some phase modulators of the plurality and a second transmission line of the pair connecting together the second inputs of other phase modulators of the plurality.

4. The apparatus according to claim 3, wherein the transmission line(s) is/are formed from a combination of series inductive elements and shunt capacitive elements which include the input capacitance of the second inputs of each phase modulator pair.

5. The apparatus according to claim 3 or claim 4, wherein the transmission line(s) has/have a characteristic impedance, and wherein the transmission line(s) is/are terminated by a terminating resistance matched to the characteristic impedance of the respective transmission line.

6. The apparatus according to any one of the preceding claims, wherein each phase shift circuit of each first and second modulator comprises a four port quadrature hybrid coupler.

7. The apparatus according to any one of the preceding claims, further comprising:
one or more first delay circuits coupling at least some of the outputs of the first phase modulators and the first inputs of the next first phase modulator of the plurality; and
one or more second delay circuits coupling at least some of the outputs of the second phase modulators and the first inputs of the next second phase modulator of the plurality.

8. The apparatus according to claim 7, wherein each delay circuit is provided by a serpentine connector track with a characteristic impedance matched to that of the modulated signal path.

9. The apparatus according to claim 7 or claim 8, wherein the first and second delay circuits are provided such that overall delays experienced by modulated carrier signals passing through the first and second phase modulators approximately match overall delays experienced a modulation signal received at the modulation signal input.

10. The apparatus according to any one of the preceding claims, further comprising:
one or more first amplifiers coupling at least some of the outputs of the first phase modulators and the first inputs of the next first phase modulator of the plurality; and
one or more second amplifiers coupling at least some of the outputs of the second phase modulators and the first inputs of the next second phase modulator of the plurality.

11. The apparatus according to any one of the preceding claims, wherein the variable capacitance diodes of each first phase modulator have an opposite polarity to corresponding variable capacitance diodes of each second phase modulator.

12. The apparatus according to any one of the preceding claims, further comprising a control input for each variable capacitance diode to control reverse biasing of said variable capacitance diodes.

13. The apparatus according to any one of the preceding claims, further comprising a carrier signal generation module for generating a carrier signal coupled to the carrier signal input of the apparatus and/or an antenna for receiving radio signals for coupling to the modulation signal input of the apparatus.

14. The apparatus according to any one of the preceding claims, further comprising first and second analogue-to-digital converters for generating first and second digital phase signals based on the first and second outputs of the apparatus respectively, wherein the apparatus optionally further comprises a differential digital phase demodulator for generating a digital output based on the first and second digital phase signals.

15. A method comprising
coupling a first input of a first phase modulator of a first phase modulator pair of a plurality of phase modulator pairs to a carrier signal input, wherein first inputs of first phase modulators of other phase modulator pairs of the plurality are coupled to an output of the preceding first phase modulator of the plurality;
coupling a first input of a second phase modulator of the first phase modulator pair of the plurality to the carrier signal input, wherein first inputs of second phase modulators of the other phase modulator pairs are coupled to an output of the preceding second phase modulator of the plurality;
coupling a second input of each first and second phase modulator to a modulation signal input;
coupling outputs of the first and second phase modulators of the last phase modulator pair of the plurality to first and second outputs;
phase shifting a signal at the respective first input of each first phase modulator of the plurality based on a signal at the respective second input, wherein the phase shift is dependent on the capacitance of variable capacitance diodes of the respective first phase modulator, said capacitance being dependent on the signal received at the second input, wherein the first phase modulator has a positive phase-voltage slope; and
phase shifting a signal at the respective first input of each second phase modulator of the plurality based on a signal at the respective second input, wherein the phase shift is dependent on the capacitance of variable capacitance diodes of the respective second phase modulator, said capacitance being dependent on the signal received at the second input, wherein the second phase modulator has a negative phase-voltage slope.
